(19) Europäisches Patentamt
European Patent Office
Office européen des brevets

(11) **EP 0 967 698 B1**

(12) **EUROPÄISCHE PATENTSCHRIFT**

(45) Veröffentlichungstag und Bekanntmachung des Hinweises auf die Patenterteilung:
**06.10.2004 Patentblatt 2004/41**

(51) Int Cl.⁷: **H01S 5/068**

(21) Anmeldenummer: **99111319.2**

(22) Anmeldetag: **08.06.1999**

(54) **Wellenlängenstabilisierte Laseranordnung**

Wavelength stabilised laser device

Dispositif laser à longueur d'onde stabilisé

(84) Benannte Vertragsstaaten:
**DE FR GB**

(30) Priorität: **22.06.1998 DE 19827699**

(43) Veröffentlichungstag der Anmeldung:
**29.12.1999 Patentblatt 1999/52**

(73) Patentinhaber: **Infineon Technologies AG**
**81669 München (DE)**

(72) Erfinder: **Auracher, Franz Dr.**
**82065 Baierbrunn (DE)**

(74) Vertreter:
**Müller, Wolfram Hubertus, Dr. Dipl.-Phys.**
**Patentanwälte**
**Maikowski & Ninnemann,**
**Postfach 15 09 20**
**10671 Berlin (DE)**

(56) Entgegenhaltungen:
EP-A- 0 818 857     FR-A- 2 379 310
US-A- 4 907 237     US-A- 5 042 042

• **PATENT ABSTRACTS OF JAPAN vol. 014, no. 296 (P-1067), 26. Juni 1990 (1990-06-26) & JP 02 093409 A (MITSUBISHI ELECTRIC CORP), 4. April 1990 (1990-04-04)**

**Beschreibung**

Die Erfindung betrifft eine wellenlängenstabilisierte Laseranordnung nach Anspruch 1.

Es ist bereits bekannt, in optischen Übertragungssystemen auf einem Halbleiterlaser basierende Lasermodule zu verwenden, die zur Erzielung einer hohen Übertragungskapazität im Wellenlängenmultiplex-(WDM-) Verfahren betrieben werden. Um möglichst viele Kanäle übertragen zu können, müssen die Lasermodule hohen Anforderungen bezüglich ihrer Wellenlängenstabilität genügen.

Ferner ist es bereits bekannt, derartige hochratige Lasermodule mit einem optischen Isolator auszurüsten. Der optische Isolator hat die Funktion, unerwünschte Rückwirkungen durch reflektiertes Laserlicht auf den Halbleiterlaser zu unterdrücken.

Eine wellenlängenstabilisierte Laseranordnung ist in der nicht vorveröffentlichten deutschen Patentanmeldung DE 197 12 845.9 beschrieben. Zur Wellenlängenstabilisierung werden aus dem Laserlichtbündel zwei Teilstrahlen ausgekoppelt und von jeweiligen Detektoren detektiert. Zur Auskopplung der Teilstrahlen werden Strahlteiler oder Spiegel verwendet. Mindestens einer der Teilstrahlen durchläuft ein optisches Filter mit einer wellenlängenabhängigen Transmission, so daß das entsprechende detektierte Signal wellenlängenabhängig ist. Durch einen Vergleich des wellenlängenabhängigen Signals mit dem wellenlängenunabhängigen Signal des anderen Detektors wird die aktuelle Wellenlänge des Halbleiterlasers ermittelt und eine Abweichung zu einem vorgegebenen Sollwert bestimmt. Die Einstellung der Laserwellenlänge auf die Sollwellenlänge erfolgt dann über eine Temperaturregelung des Halbleiterlasers.

Der Erfindung liegt die Aufgabe zugrunde, einen einfachen und kostengünstigen Aufbau einer für hohe Übertragungskapazitäten und insbesondere für Wellenlängenmultiplex geeigneten Laseranordnung mit einem Halbleiterlaser zu schaffen.

Zur Lösung der Aufgabe sind die Merkmale des Anspruchs 1 vorgesehen.

Die erfindungsgemäße Laseranordnung weist sowohl eine Wellenlängenstabilisierung als auch einen optischen Isolator auf und ist daher in besonderem Maße für die Übertragung hoher Datenraten im WDM-Betrieb geeignet. Erfindungsgemäß wird dabei zumindest einer der für die Wellenlängenstabilisierung benötigten Teilstrahlen über einen Polarisator des optischen Isolators ausgekoppelt. Der Polarisator erfüllt somit gleichzeitig zwei Funktionen, nämlich die eines Polarisators im optischen Isolator und die eines Strahlteilers in der Wellenlängenstabilisierungsschaltung. Dadurch wird ein Strahlteiler als zusätzliches Bauelement eingespart und es wird ein einfacher und kompakter Gesamtaufbau erzielt.

Vorzugsweise wird (zumindest) der zweite Polarisator als Strahlteiler eingesetzt und zur Auskopplung des zweiten Teilstrahls verwendet. In diesem Fall wirkt sich günstig aus, daß der optische Isolator Reflexe von dem Filter und von dem zweiten Detektor unterdrückt und somit verhindert, daß diese auf den Halbleiterlaser zurückwirken.

Ferner wird zweckmäßigerweise (auch) der erste Polarisator als Strahlteiler zur Auskopplung des ersten Teilstrahls eingesetzt. Auf diese Weise wird der Integrationsgrad und die Kompaktheit der erfindungsgemäßen Anordnung durch Einsparung eines weiteren Strahlteilers weiter gefördert.

Eine bevorzugte Ausgestaltung der Erfindung kennzeichnet sich dadurch, daß das Filter ein Kantenfilter oder ein Bandpaßfilter ist. Bei Verwendung eines Bandpaßfilters wird dieses an einer der Bandpaß-Filterkanten betrieben.

Eine weitere bevorzugte Ausgestaltung der Erfindung kennzeichnet sich dadurch, daß ein weiteres Filter zur Filterung des zum ersten Detektor geführten ersten Teilstrahls eingesetzt wird. Dabei ist vorteilhaft, daß beide Filter mit linear polarisiertem Licht betrieben werden. Dies reduziert die an die Filter zu stellenden Anforderungen und ermöglicht den Einsatz kostengünstiger Filter.

Bei der Verwendung von zwei Filtern ist es bevorzugt, im Strahlengang des ersten Teilstrahls zwischen dem ersten Polarisator und dem weiteren Filter ein $\lambda/2$-Plättchen mit einer geeigneten Orientierung seiner optischen Achse anzuordnen. Das $\lambda/2$-Plättchen dient der Unterdrückung von an dem weiteren Filter auftretenden Reflexionen (sog. "Quasi-Isolator").

Vorzugsweise weist das weitere Filter eine gegenüber der Filterkurve des Filters verschobene und bezüglich der Sollwel-Sollwellenlänge $\lambda_0$ gegenläufige Filterkurve auf. Durch eine geeignete Auswertung der Detektorsignale kann in diesem Fall eine bei gleicher Filtersteilheit doppelt so hohe Wellenlängenempfindlichkeit wie bei der Verwendung nur eines Filters erzielt werden.

Bei der Verwendung von zwei Filtern ist es ferner vorteilhaft, wenn die Filterkurve des Filters und die Filterkurve des weiteren Filters bei der Sollwellenlänge $\lambda_0$ einen Schnittpunkt aufweisen. In diesem Fall kann die Wellenlänge des Halbleiterlasers mittels einer Nullpunktsregelung auf die Sollwellenlänge $\lambda_0$ eingeregelt werden.

Eine weitere bevorzugte Ausgestaltung der Erfindung kennzeichnet sich dadurch, daß das Filter und/oder das weitere Filter schwenkbar angeordnet sind. Die schwenkbare Anordnung eines Filters ermöglicht es, durch eine Verkippung des Filters relativ zu der Achse des einfallenden Teilstrahls eine Verstellung und Justage der Mittenwellenlänge $\lambda_M$ des Filters vorzunehmen. Dadurch kann mit dem gleichen Filter ein ganzer Bereich von unterschiedlichen Sollwellenlängen abgedeckt werden, wodurch sich auch wechselnde Einsatzbedingungen ohne die Notwendigkeit eines Filteraustausches beherrschen lassen. Ferner ist eine einfache Justagemöglichkeit gegeben, die es erlaubt, die an das Filter zu stellenden Toleranzanforderungen in Hinblick auf die Einhaltung der Mittenwellenlänge $\lambda_M$ zu reduzieren.

Anstelle der Filter können auch der zweite Polarisator und/oder der erste Polarisator schwenkbar angeordnet sein, wodurch derselbe Effekt erzielt wird.

Eine besonders kompakte Anordnung wird erreicht, wenn der zweite Polarisator und das Filter in zueinander lagefester Beziehung in einer gemeinsamen, schwenkbaren Einheit angeordnet sind.

Die Einrichtung zum Drehen der Polarisationsebene ist vorzugsweise als ein Faradaydreher ausgebildet. In diesem Fall kennzeichnet sich eine bevorzugte Ausgestaltung der Erfindung dadurch, daß der Faradaydreher selbst permanent magnetisiert ist. Derartige Faradaydreher brauchen nicht mit einem äußeren Premanentmagneten ausgestattet werden, welcher die seitliche Auskopplung des oder der auszukoppelnden Teilstrahlen über den oder die Polarisatoren behindern oder erschweren kann.

Aufgrund ihrer Kompaktheit und Vielseitigkeit ist die erfindungsgemäße wellenlängenstabilisierte Laseranordnung insbesondere zum Aufbau von hochratigen Lasermodulen kleiner Baugrößen geeignet. Ein solches Lasermodul umfaßt neben der wellenlängenstabilisierten Laseranordnung ein hermetisch dichtes Modulgehäuse, das den Halbleiterlaser, den optischen Isolator und zumindest die optischen Detektoren und das optische Filter der Regeleinrichtung aufnimmt. Eine derartiges Lasermodul weist bei einer kompakten und kostengünstigen Aufbauweise den Vorteil einer internen Wellenlängenreferenz auf. Vorteilhaft ist ferner, daß bei einem solchen Modul die Anforderungen an das Filter weiter reduziert sind, da das Filter keinerlei Feuchtigkeit ausgesetzt ist und auch eine konstante Betriebstemperatur des Filters durch Ankopplung an eine den Halbleiterlaser kühlende Kühleinrichtung in einfacher Weise herbeigeführt werden kann.

Weitere vorteilhafte Ausgestaltungen der Erfindung sind in den Unteransprüchen angegeben.

Die Erfindung wird nachfolgend in beispielhafter Weise anhand eines Ausführungsbeispiels und Varianten desselben unter Bezugnahme auf die Zeichnung beschrieben; in dieser zeigt:

Fig. 1 eine schematische Darstellung eines Ausführungsbeispiels der Erfindung;

Fig. 2 eine Darstellung zur Erläuterung des Aufbaus und der Wirkungsweise eines optischen Isolators;

Fig. 3a ein Diagramm, das die Wellenlängenabhängigkeit der Transmission eines optischen Hochpaßfilters und eines optischen Tiefpaßfilters zeigt;

Fig. 3b ein Diagramm, das die Wellenlängenabhängigkeit der Transmission zweier optischer Bandpaßfilter zeigt;

Fig. 3c ein Diagramm, das bzgl. der Fig. 3a die funktionale Abhängigkeit des Istwertes $(I_1-I_2)/(I_1+I_2)$ von der Wellenlänge für den Fall zeigt, daß die beiden Filter ein Hochpaß- und ein Tiefpaßfilter sind, deren Transmissionskurven sich bei der Mittelwertlänge $\lambda_M$ schneiden;

Fig. 4 eine schematische Seitenansicht einer ersten Variante des in Fig. 1 dargestellten Ausführungsbeispiels;

Fig. 5 eine schematische Seitenansicht einer zweiten Variante des in Fig. 1 dargestellten Ausführungsbeispiels;

Fig. 6 eine schematische Seitenansicht einer dritten Variante des in Fig. 1 dargestellten Ausführungsbeispiels;

Fig. 7a eine schematische Darstellung einer vierten Ausführungsvariante des in Fig. 1 dargestellten Ausführungsbeispiels in Draufsicht; und

Fig. 7b eine Seitenansicht der in Fig. 7a dargestellten vierten Ausführungsvariante aus Richtung des Pfeils X in der Fig. 7a.

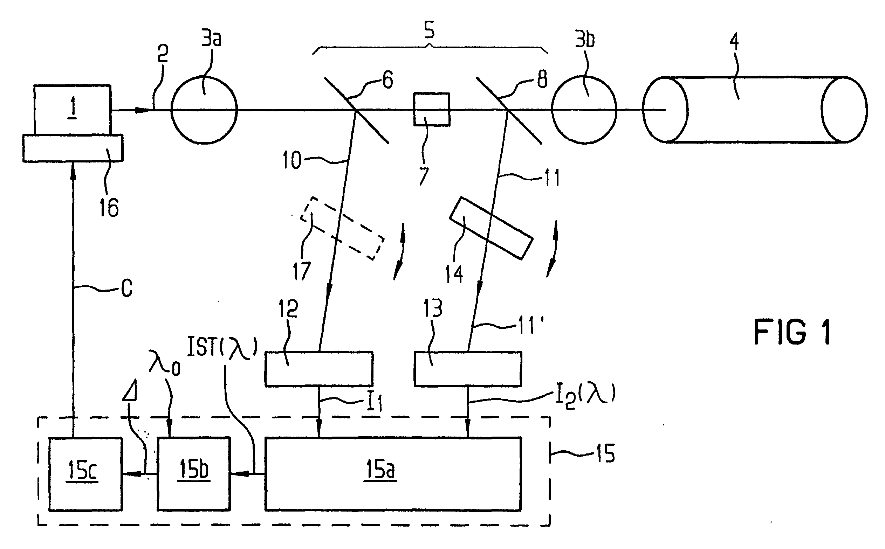

Nach Fig. 1 weist ein Ausführungsbeispiel der Erfindung einen Halbleiterlaser 1 auf, der ein Laserlichtbündel 2 emittiert. Das Laserlichtbündel 2 wird von einer Optik, die aus einer oder mehreren Linsen bestehen kann, kollimiert oder auf eine Eintrittsfläche einer Glasfaser 4 fokussiert. Im letztgenannten Fall kann die Optik wie hier dargestellt beispielsweise aus zwei Linsen (oder Linsengruppen) 3a, 3b bestehen, wobei die erste Linse 3a ein näherungsweise kollimiertes Laserlichtbündel erzeugt, das von der zweiten Linse 3b fokussiert wird.

Im Strahlengang hinter der Linse 3a befindet sich ein optischer Isolator 5, der aus einem ersten Polarisator 6, einem Faradaydreher 7 und einem zweiten Polarisator 8 aufgebaut ist.

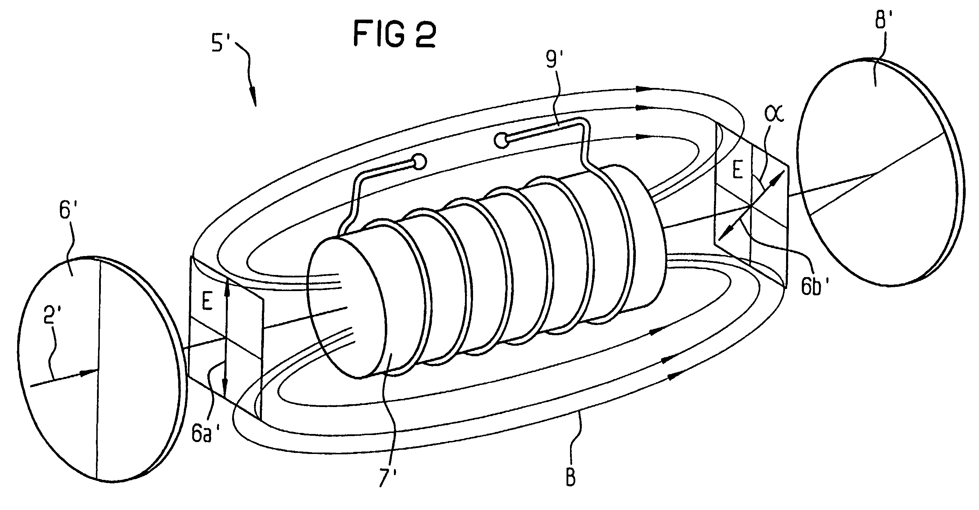

Ein optischer Isolator ist als solcher in der Technik bekannt und dient dazu, unerwünschte Rückwirkungen von reflektiertem Laserlicht auf den Halbleiterlaser 1 zu unterdrücken. Der prinzipielle Aufbau und die Wirkungsweise eines optischen Isolators 5' sind in Fig. 2 näher dargestellt. Der optische Isolator 5' weist einen ersten Polarisator 6', einen Faradaydreher 7' und einen zweiten Polarisator 8' auf. Der erste Polarisator 6' erzeugt ein linear polarisiertes Laserlichtbündel 2', dessen Polarisationsrichtung durch die Polarisationsebene des ersten Polarisators 6' bestimmt und durch den in Fig. 2 gezeigten Vektor 6a' der elektrischen Feldstärke E angegeben ist. Beim Durchlaufen des Faradaydrehers 7' wird der Vektor 6a' der elektrischen Feldstärke um einen vorgegebenen Drehwinkel $\alpha$ (bspw. $\alpha$ = 45°) gedreht. Für diese auf dem sog. Faradayeffekt beruhende Drehung der Polarisationsebene bedarf es eines Magnetfeldes B, das beispielsweise von außen mittels einer Magnetspule 9' oder eines Permanentmagneten an den Faradaydreher 7' angelegt wird. Das Bezugszeichen 6b' kennzeichnet den Vektor der elektrischen Feldstärke des Laserlichtbündels 2' nach Durchlaufen des Faradaydrehers 7'. Der zweite Polarisator 8' ist so eingestellt, daß seine Polarisationsebene mit dem Vektor 6b' zusammenfällt. Das Laserlichtbündel 2' kann somit den zweiten Polarisator 8' ungehindert passieren.

Zurückkehrende Lichtreflexe "sehen" im Faradaydreher 7' ein entgegengesetzt gerichtetes Magnetfeld B. Ihre durch den zweiten Polarisator 8' vorgegebene Polarisationsrichtung wird deshalb bzgl. der Strahlrichtung mit entgegengesetztem Drehsinn verdreht. Die sich ergebende Polarisationsrichtung hinter dem Faradaydreher 7' ist senkrecht zu dem Vektor 6a' orientiert. Folglich kann der Reflex den Polarisator 6' nicht passieren, wodurch eine unerwünschte Rückwirkung auf den Halbleiterlaser 1 ausgeschlossen ist.

Bei einer erfindungsgemäßen Anordnung wird zumindest einer der Polarisatoren 6, 8 - oder wie in Fig. 1 dargestellt vorzugsweise beide Polarisatoren 6, 8 - zur Auskopplung von ersten und zweiten Teilstrahlen 10, 11 aus dem Laserlichtbündel 2 genutzt. Hierzu werden die Normalen der Polarisatoren 6, 8 gegenüber der Strahlachse des Laserlichtbündels 2 verkippt.

Die Polarisatoren 6, 8 werden somit als Strahlteiler genutzt. Ein geeignetes Auskoppelverhältnis für die Intensitäten der ersten und zweiten Teilstrahlen 10, 11, kann durch eine entsprechende Ver- oder Entspiegelung der Polarisatoren 6, 8 eingestellt werden.

Der erste Teilstrahl 10 fällt direkt auf einen ersten Detektor 12 und wird von diesem in ein erstes elektrisches Detektorsignal $I_1$ umgewandelt. Das erste Detektorsignal $I_1$ entspricht der Intensität des ersten Teilstrahl 10 und ist somit proportional zu der Intensität des Laserlichtbündels 2.

Der zweite Teilstrahl 11 läuft durch ein optisches Filter 14. Bei dem optischen Filter 14 kann es sich um ein Kantenfilter (Hochpaß- oder Tiefpaßfilter) oder um ein an einer seiner Filterkanten betriebenes Bandpaßfilter handeln. Konstruktiv kann das Filter 14 beispielsweise als dielektrisches Filter oder als Etalon ausgeführt sein.

Der durch das Filter 14 hindurchgetretene, gefilterte zweite Teilstrahl 11' trifft auf einen zweiten Detektor 13. Der zweite Detektor 13 erzeugt ein zweites elektrisches Detektorsignal $I_2(\lambda)$. Das zweite elektrische Detektorsignal $I_2(\lambda)$ ist einerseits proportional zu der Intensität des Laserlichtbündels 2 und es ist andererseits aufgrund der Filtercharakteristik des Filters 14 von der Laserlicht-Wellenlänge $\lambda$ abhängig.

Um Rückwirkungen auf den Halbleiterlaser durch Reflexionen an den Detektoren 12 und 13 zu vermeiden, sind die ersten und zweiten Teilstrahlen 10, 11' jeweils gegenüber den Detektornormalen verkippt. Insbesondere beim ersten Detektor 12 ist eine Verkippung zweckmäßig, da dessen Reflex nicht durch den optischen Isolator 5 eliminiert wird.

Die beiden Detektorsignale $I_1$ und $I_2(\lambda)$ werden einer Regelelektronik 15 zugeführt, die eine Signalverarbeitungseinrichtung 15a, eine Vergleichseinrichtung 15b und eine Ansteuereinrichtung 15c umfaßt.

Die Signalverarbeitungseinrichtung 15a ermittelt aus den beiden Detektorsignalen $I_1$ und $I_2(\lambda)$ ein Istwertsignal IST($\lambda$), welches für die aktuelle Laserlicht-Wellenlänge $\lambda$ repräsentativ und unabhängig von der Intensität des Laserlichtbündels 2, d.h. von der Leistung des Halbleiterlasers 1, ist.

Als Istwertsignal IST($\lambda$) kann beispielsweise der Quotient aus dem zweiten Detektorsignal $I_2(\lambda)$ und dem ersten Detektorsignal $I_1$ verwendet werden, d.h. IST($\lambda$) = $I_2(\lambda)/I_1$, da sich in diesem Fall die Leistungsabhängigkeit dieser beiden Signale gerade herauskürzt.

Eine der Signalverarbeitungseinrichtung 15a nachgeschaltete Vergleichseinrichtung 15b vergleicht IST($\lambda$) mit einem Sollwertsignal SOLL, das eine gewünschte Sollwellenlänge $\lambda_0$ vorgibt. Die Vergleichseinrichtung 15b stellt ein Signal $\Delta$ bereit, das für die Abweichung zwischen IST($\lambda$) und SOLL repräsentativ ist. Die Sollwellenlänge $\lambda_0$ kann dabei von außen veränderlich vorgegeben werden.

Das Abweichungssignal $\Delta$ wird der Ansteuereinrichtung 15c zugeführt. Die Ansteuereinrichtung 15c erzeugt daraufhin ein Steuersignal C, das einem Kühlelement 16, beispielsweise einem Peltier-Element, zugeleitet wird. Das Kühlelement 16 steht mit dem Halbleiterlaser 1 in gutem thermischen Kontakt. Die Regelung der Laserlicht-Wellenlänge $\lambda$ erfolgt über die Temperaturabhängigkeit der Laserlichtemission in bezug auf $\lambda$.

Die Vergleichseinrichtung 15b und die Ansteuereinrichtung 15c können beispielsweise in Form eines PI- oder eines PID-Reglers oder auch als digitaler Regler realisiert sein.

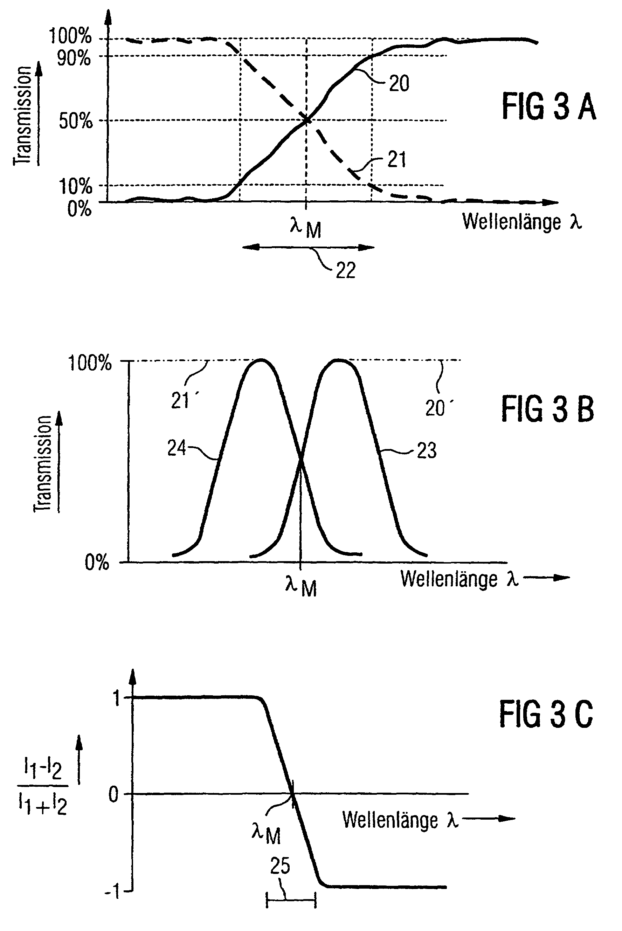

In Fig. 3a ist die wellenlängenabhängige Transmission eines optischen Hochpaß- (Filterkurve 20) und eines optischen Tiefpaßfilters (Filterkurve 21) dargestellt, wie sie beispielsweise als Filter 14 zur Anwendung kommen können. Für eine hohe spektrale Auflösung sollten die Filterflanken möglichst steil sein. Allerdings ist zu berücksichtigen, daß eine hohe Flankensteilheit den Fangbereich 22 der Regelung verkleinert.

Die Mittenwellenlänge $\lambda_M$ eines Filters ist durch die Bedingung "Transmission($\lambda_M$) = 50%" bestimmt. Die Mittenwellenlängen der in Fig. 3a dargestellten Filter sind identisch. Vorzugsweise wird ein Filter verwendet, das bezüglich der gewünschten Sollwellenlänge $\lambda_0$ in der Nähe seiner Mittenwellenlänge $\lambda_M$ be-

trieben werden kann (d.h. $\lambda_M \approx \lambda_0$), da auf diese Weise ein Arbeitspunkt bei maximaler Steilheit der Filterkurve 20; 21 sowie ein symmetrischer Fangbereich 22 erhalten werden.

Es ist auch möglich, zur Wellenlängenregelung ein weiteres wellenlängenselektives Filter 17 zu verwenden. Ein solches ist in Fig. 1 strichpunktiert im Strahlengang des ersten Teilstrahls 10 eingezeichnet. In diesem Fall ist auch das erste Detektorsignal $I_1$ wellenlängenabhängig, d.h. $I_1(\lambda)$.

Die beiden Filter 14, 17 weisen vorzugsweise möglichst gegenläufige (komplementäre) Filterkurven bzgl. der Sollwellenlänge $\lambda_0$ auf. In Fig. 3b sind geeignete Filterkurven für das Filter 14 und das Filter 17 dargestellt. Bei Verwendung von Bandpaßfiltern kann eines der Filter 14; 17 eine Filterkurve 23 und das andere Filter 17; 14 eine Filterkurve 24 aufweisen. Beide Bandpaßfilter werden vorzugsweise im Bereich ihrer Mittelwellenlängen $\lambda_M$ betrieben, die - wie hier dargestellt - zweckmäßigerweise identisch sein sollten. Bei Verwendung von Kantenfiltern können Filter gemäß den strichpunktiert eingezeichneten Filterkurven 20' (Hochpaßfilter) und 21' (Tiefpaßfilter) gewählt werden, die den in Fig. 3a dargestellten Filterkurven 20, 21 entsprechen. Die Kombination eines Kantenfilters mit einem Bandpaßfilter ist ebenfalls möglich.

Bei Verwendung von zwei Filtern 14, 17 kann das von der Laserleistung unabhängige Istwertsignal IST($\lambda$) beispielsweise über die Beziehung

$$IST(\lambda) = (I_1(\lambda) - I_2(\lambda))/(I_1(\lambda) + I_2(\lambda))$$

ermittelt werden. Fig. 3c zeigt den funktionalen Verlauf von IST($\lambda$) bei Zugrundelegung der Filterkurven 20 und 21, d.h. von zwei Kantenfiltern (Hochpaß- und Tiefpaßfilter) mit identischen Mittenwellenlängen $\lambda_M$. Bei gleicher Filtersteilheit wird eine doppelt so große Wellenlängenempfindlichkeit wie bei der Verwendung nur eines Filters 14 erreicht. Ferner ist für den Fall $\lambda_M = \lambda_0$ eine Nullpunktsregelung möglich.

Das Filter 14 sowie das optionale Filter 17 sind vorzugsweise schwenkbar angeordnet. Dies ermöglicht eine gezielte Einstellung der Mittenwellenlänge $\lambda_M$ durch Verkippung des jeweiligen Filters 14, 17 gegenüber der Strahlachse des ersten bzw. zweiten Teilstrahls 10, 11. Dadurch kann die erfindungsgemäße Anordnung ohne einen Filterwechsel für einen breiten Bereich von Sollwellenlängen $\lambda_0$ eingesetzt werden, es können die Toleranzanforderungen an die Filter 14, 17 bzgl. der Einhaltung einer Mittenwellenlänge $\lambda_M$ in einem vernünftigen Rahmen gehalten werden, und es kann ein Abgleich der Mittenwellenlänge $\lambda_M$ auf die Sollwellenlänge $\lambda_0$ sowie bei Verwendung von zwei Filtern 14, 17 ein Abgleich der Mittenwellenlängen der beiden Filter 14, 17 untereinander durchgeführt werden.

Neben der Auskopplung der Teilstrahlen 10, 11 unterscheidet sich der optische Isolator 5 von dem in Fig. 2 dargestellten optischen Isolator 5' dadurch, daß für den Faradaydreher 7 vorzugsweise ein permanent magnetisiertes Material eingesetzt wird, wodurch ein ein externes Magnetfeld B erzeugender äußerer Magnet (etwa die Magnetspule 9') entfallen kann. Dadurch wird die erfindungsgemäße seitliche Strahlauskopplung an den Polarisatoren 6, 8 wesentlich erleichtert.

Es sind eine Vielzahl von Abwandlungen des in Fig. 1 dargestellten Ausführungsbeispiels möglich. Beispielsweise muß der erste Teilstrahl 10 nicht am ersten Polarisator 6 aus dem Laserlichtbündel 2 ausgekoppelt werden, sondern kann in alternativer Weise auch aus dem zweiten Teilstrahl 11 vor Durchlaufen des Filters 14 oder an einer Reflexionsschicht desselben ausgekoppelt werden. Handelt es sich bei dem Halbleiterlaser 1 um einen Kantenemitter, besteht ferner die Möglichkeit, als ersten Teilstrahl 11 einen Laserstrahl zu nutzen, der an einer Kante des Halbleiterlasers 1 emittiert wird, die der das Laserlichtbündel 2 emittierenden Kante gegenüberliegt.

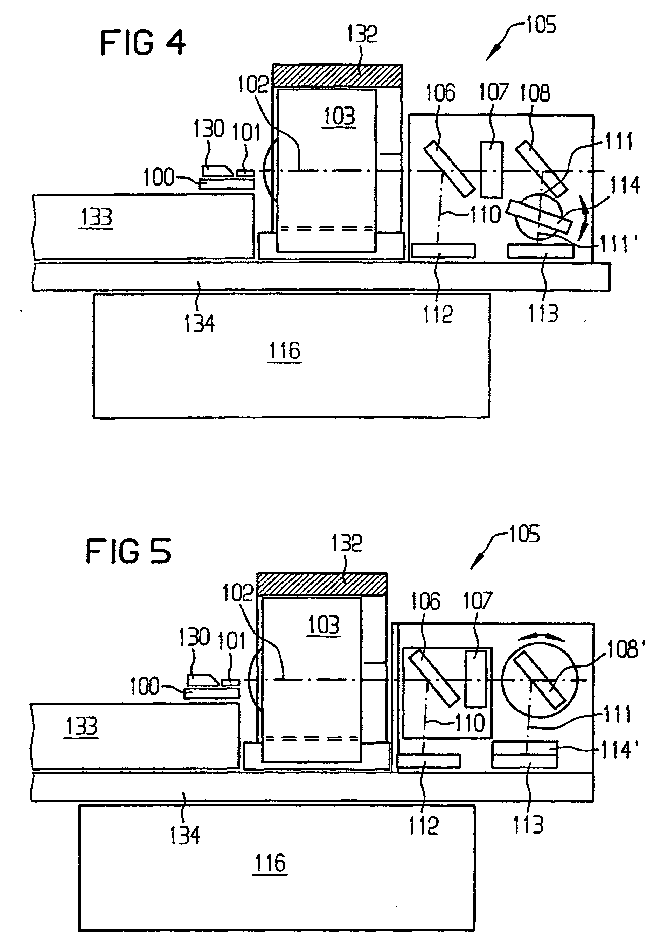

Fig. 4 zeigt eine erste praktische Ausführungsvariante des in Fig. 1 dargestellten Ausführungsbeispiels.

Ein Laserchip 101 ist auf einem Siliziumträger 100 angeordnet. Auf dem auch als Silizium-Submount bezeichneten Träger 100 ist ferner ein Umlenkprisma 130 montiert, mittels dem ein an einer rückwärtigen Kante des Laserchips 101 austretendes weiteres Laserlichtbündel umgelenkt und ausgekoppelt werden kann.

Das von dem Laserchip 101 emittierte Laserlichtbündel 102 durchläuft eine beispielsweise asphärische Linse 103, die in einer Linsenfassung 132 justierbar gehaltert ist, und gelangt in einen optischen Isolator 105. Der optische Isolator 105 umfaßt in der bereits beschriebenen Weise einen ersten Polarisator 106, einen Faradaydreher 107 und einen zweiten Polarisator 108. Die Polarisatoren 106, 108 sind zur Auskopplung von ersten und zweiten Teilstrahlen 110, 111 gegenüber der Strahlachse des Laserlichtbündels 102 geneigt angeordnet. Der zweite Teilstrahl 111 durchläuft ein schwenkbar angeordnetes optisches Filter 114. Mit den Bezugszeichen 112 und 113 sind erste und zweite optische Detektoren bezeichnet, die wie in Fig. 1 einen ersten bzw. einen gefilterten zweiten Teilstrahl 110 bzw. 111' empfangen.

Der Siliziumträger 100 ist beispielsweise auf einer AlN-Grundplatte 133 angebracht und steht mit dieser in gutem Wärmekontakt. Die Grundplatte 133, die Linsenfassung 132 und der optische Isolator 105 sind gemeinsam auf einer Platte 134 montiert. Die Platte 134 kann aus Silizium oder AlN bestehen und ist auf einer Kühlfläche eines Peltier-Elements 116 unter Ausbildung eines guten Wärmeübergangs angebracht. Die Temperatur des Peltier-Elements 116 wird in der bereits beschriebenen Weise zur Konstanthaltung der Laserwellenlänge $\lambda$ geregelt. Durch den dargestellten Aufbau wird auch eine gute Temperaturkonstanz an der Linse 103, an dem optischen Isolator 105 und an dem Filter 114 erzielt.

Zur Justage der Mittenwellenlänge $\lambda_M$ wird durch Verschwenken des Filters 114 der Kippwinkel desselben bzgl. der Strahlachse des zweiten Teilstrahls 111 verstellt. Das Filter 114 wird dann durch Schweißen, Löten oder Kleben in der gefundenen Justagestellung fixiert.

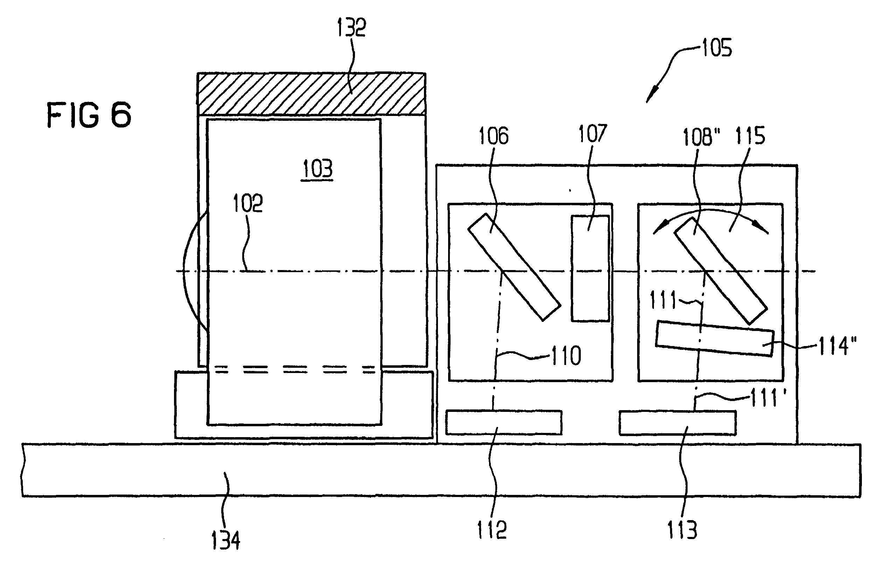

Fig. 5 zeigt eine zweite Ausführungsvariante der Erfindung. Gleiche Teile wie in der Fig. 4 sind mit den gleichen Bezugszeichen gekennzeichnet. Die in Fig. 5 gezeigte Ausführungsvariante unterscheidet sich von der in Fig. 4 dargestellten Variante im wesentlichen nur dadurch, daß anstelle der Verstellung des Kippwinkels des Filters 114 hier der Kippwinkel des zweiten Polarisators 108' zu Justagezwecken verstellbar ist. Hierfür ist der zweite Polarisator 108' an einer drehbar gelagerten, arretierbaren Achse angebracht, während das Filter 114' ortsfest ist. Es kann beispielsweise unmittelbar auf dem Eintrittsfenster des zweiten Detektors 113 fixiert sein.

Fig. 6 zeigt eine dritte Ausführungsvariante der Erfindung, wobei auch hier gleiche Teile wie in den Fig. 4 und 5 mit den gleichen Bezugszeichen gekennzeichnet sind. Die in Fig. 6 gezeigte Ausführungsvariante unterscheidet sich von den in Fig. 4 und 5 dargestellten Varianten im wesentlichen dadurch, daß hier eine Einheit 115 bestehend aus dem zweiten Polarisator 108" und dem Filter 114" kippverstellbar angeordnet ist, wobei eine feste Relativlage zwischen dem zweiten Polarisator 108" und dem Filter 114" vorgesehen ist.

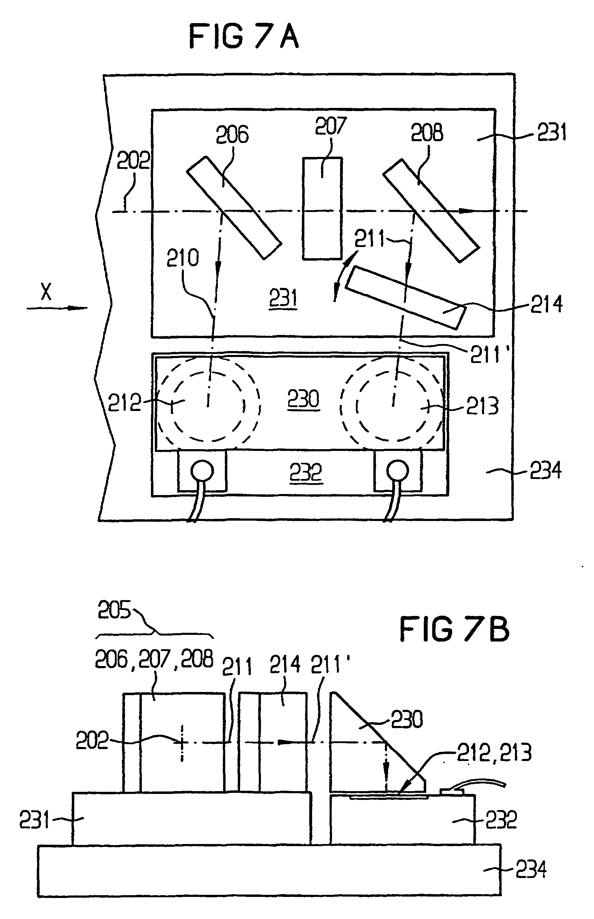

Fig. 7a zeigt in Draufsicht eine Teildarstellung einer vierten Ausführungsvariante des in Fig. 1 dargestellten Ausführungsbeispiels. Gegenüber den in den Fig. 4 bis 6 dargestellten Ausführungsvarianten ist hier die Anordnung aus erstem und zweitem Polarisator 206 und 208, Faradaydreher 207, Filter 214 und erstem und zweitem Detektor 212 und 213 um 90° gekippt. Das Laserlichtbündel 202 und die ausgekoppelten Teilstrahlen 210, 211, 211' verlaufen somit in einer Ebene parallel zu einer Basisplatte 234, die der Platte 134 in den Fig. 4 bis 6 entspricht und die in nicht dargestellter Weise den Laserchip trägt. Das Filter 214 ist um eine Achse senkrecht zu der Basisplatte 234 verschwenkbar, während der zweite Polarisator 208 lagefest ausgeführt ist. In bezug auf die Justageverhältnisse entspricht die Anordnung somit der in Fig. 4 gezeigten ersten Ausführungsvariante. In analoger Weise können bei der gekippten vierten Ausführungsvariante auch die anhand der Fig. 5 und 6 erläuterten Justagemöglichkeiten (schwenkbarer zweiter Polarisator 208 bzw. schwenkbare Einheit aus zweitem Polarisator 208 und Filter 214) realisiert sein.

Fig. 7b zeigt eine Seitenansicht der vierten Ausführungsvariante aus Richtung des Pfeils X in Fig. 7a. Der optische Isolator 205 und das Filter 214 sind auf einem gemeinsamen, ersten Zwischenträger 231 angebracht, während die Detektoren 212, 213 auf einem benachbart angeordneten Detektorträger 232 aufgebracht sind. Oberhalb des Detektorträgers 232 befindet sich ein Umlenkprisma 230, das die beiden Teilstrahlen 210 und 211' auf die jeweiligen Detektoren 212, 213 umlenkt. Der Umlenkwinkel wird zweckmäßigerweise etwas von 90° abweichend gewählt, damit das von den Detektoren 212, 213 reflektierte Licht nicht auf den Laserchip zurücktrifft.

Die in den Fig. 7a, 7b gezeigte vierte Ausführungsvariante der Erfindung ist insbesondere dann günstig, wenn eine niedrige Bauhöhe (Standhöhe über der Grundplatte 234) der Laseranordnung gefordert ist.

Aufgrund ihres geringen Platzbedarfs lassen sich die in den Fig. 4 bis 7c gezeigten Aufbauten in einfacher Weise in einem nicht dargestellten hermetisch dichten Modulgehäuse unterbringen. Dabei können die Signalverarbeitungseinrichtung 15a, die Vergleichseinrichtung 15b und die Ansteuereinrichtung 15c außerhalb oder aber auch innerhalb des Modulgehäuses angeordnet sein.

Bezugszeichen:

| | |
|---|---|
| 1 | Halbleiterlaser |
| 2, 2' | Laserlichtbündel |
| 3a | erste Linse |
| 3b | zweite Linse |
| 4 | Glasfaser |
| 5, 5' | optischer Isolator |
| 6, 6' | erster Polarisator |
| 6a' | Vektor der el. Feldstärke |
| 6b' | Vektor der el. Feldstärke |
| 7, 7' | Faradaydreher |
| 8, 8' | zweiter Polarisator |
| 9' | Magnetspule |
| 10 | erster Teilstrahl |
| 11 | zweiter Teilstrahl |
| 11' | gefilterter zweiter Teilstrahl |
| 12 | erster Detektor |
| 13 | zweiter Detektor |
| 14 | optisches Filter |
| 15 | Regelelektronik |
| 15a | Signalverarbeitungseinrichtung |
| 15b | Vergleichseinrichtung |
| 15c | Ansteuereinrichtung |
| 16 | Kühlelement |
| 17 | weiteres optisches Filter |
| 20, 20' | Filterkurve (Hochpaßfilter) |
| 21, 21' | Filterkurve (Tiefpaßfilter) |
| 22 | Fangbereich |
| 23 | Filterkurve (Bandpaßfilter) |
| 24 | Filterkurve (Bandpaßfilter) |
| 25 | Fangbereich |
| 100 | Siliziumträger |
| 101 | Laserchip |

| 102 | Laserlichtbündel |
| 103 | Linse |
| 105 | optischer Isolator |
| 106 | erster Polarisator |
| 107 | Faradaydreher |
| 108, 108', 108" | zweiter Polarisator |
| 110 | erster Teilstrahl |
| 111 | zweiter Teilstrahl |
| 111' | gefilterter zweiter Teilstrahl |
| 112 | erster Detektor |
| 113 | zweiter Detektor |
| 114, 114', 114" | optisches Filter |
| 115 | Einheit |
| 116 | Peltier-Element |

| 130 | Umlenkprisma |
| 132 | Linsenfassung |
| 133 | Grundplatte |
| 134 | Platte |

| 202 | Laserlichtbündel |

| 205 | optischer Isolator |
| 206 | erster Polarisator |
| 207 | Faradaydreher |
| 208 | zweiter Polarisator |
| 210 | erster Teilstrahl |
| 211 | zweiter Teilstrahl |
| 211' | gefilterter zweiter Teilstrahl |
| 212 | erster Detektor |
| 213 | zweiter Detektor |
| 214 | optisches Filter |

| 230 | Umlenkprisma |
| 231 | Zwischenträger |
| 232 | Detektorträger |
| 234 | Basisplatte |

| $\alpha$ | Drehwinkel der Polarisationsebene |
| B | Magnetfeld |
| C | Steuersignal |
| $\Delta$ | Signal |
| $I_1$ | erstes Detektorsignal |
| $I_2$ | zweites Detektorsignal |
| X | Pfeil |

**Patentansprüche**

1. Wellenlängenstabilisierte Laseranordnung mit

   - einem Halbleiterlaser (1; 101) und
   - einer Regeleinrichtung, die

     -- einen ersten optischen Detektor (12; 112; 212), dem ein von dem Halbleiterlaser (1, 101) ausgekoppelter erster Teilstrahl (10) zugeführt wird,

     -- ein optisches Filter (14; 114, 114', 114"; 214)

     -- einen zweiten optischen Detektor (13; 113; 213), dem ein von dem Halbleiterlaser (1, 101) ausgekoppelter und von dem optischen Filter (14; 114, 114', 114"; 214) gefilterter zweiter Teilstrahl (11'; 111'; 211') zugeführt wird,

     -- eine Signalverarbeitungseinrichtung (15a), der ein Ausgangssignal ($I_1$) des ersten optischen Detektors (12, 112; 212) und ein Ausgangssignal ($I_2$) des zweiten optischen Detektors (13; 113; 213) zugeführt werden und die aus den beiden Ausgangssignalen ($I_1$, $I_2$) ein Istwertsignal (IST($\lambda$)) ermittelt, das für die aktuelle Laserwel-Laserwellenlänge $\lambda$ repräsentativ und unabhängig von der Laserleistung ist,

     -- eine Vergleichseinrichtung (15b), die das Istwertsignal (IST($\lambda$)) mit einem vorgegebenen, eine Sollwellenlänge $\lambda_0$ angebenden Sollwertsignal (SOLL) vergleicht und

     -- eine Ansteuereinrichtung (15c), die ein Steuersignal (C) erzeugt, das einen die zu stabilisierende Wellenlänge $\lambda$ beeinflussenden Betriebsparameter des Halbleiterlasers derart einstellt, daß das Istwertsignal (IST($\lambda$)) im wesentlichen mit dem Sollwertsignal (SOLL) übereinstimmt, umfaßt,

   - einem im Strahlengang (2, 102, 202) des Halbleiterlasers angeordneten optischen Isolator (5; 105; 205) mit

     -- einem ersten Polarisator (6; 106; 206),
     -- einer dem ersten Polarisator (6; 106; 206) nachgeschalteten Einrichtung (7; 107; 207) zum Drehen der Licht-Polarisationsebene und
     -- einem der Einrichtung (7; 107; 207) zum Drehen der Licht-Polarisationsebene nachgeschalteten zweiten Polarisator (8; 108; 208)

   - wobei zumindest einer der beiden Polarisatoren (6; 106; 206; 8; 108; 208) als Strahlteiler zur Auskopplung des ersten oder zweiten Teilstrahls (10; 110; 210; 11; 111; 211) eingesetzt ist.

2. Wellenlängenstabilisierte Laseranordnung nach Anspruch 1, **dadurch gekennzeichnet, daß** der zweite Polarisator (8; 108; 208) als Strahlteiler zur Auskopplung des zweiten Teilstrahls (11; 111; 211) eingesetzt ist.

3. Wellenlängenstabilisierte Laseranordnung nach Anspruch 1 oder 2, **dadurch gekennzeichnet, daß** der erste Polarisator (6; 106; 206) als Strahlteiler zur Auskopplung des ersten Teilstrahls (10; 110; 210) eingesetzt ist.

4. Wellenlängenstabilisierte Laseranordnung nach einem der vorhergehenden Ansprüche, **dadurch gekennzeichnet, daß** der oder die als Strahlteiler eingesetzten Polarisatoren (6; 106; 206; 8; 108; 208) teilverspiegelte Polarisationsfilter sind, die gegenüber einem einfallenden Laserlichtbündel (2, 102, 202) geneigt angeordnet sind.

5. Wellenlängenstabilisierte Laseranordnung nach einem der vorhergehenden Ansprüche, **dadurch gekennzeichnet, daß** das optische Filter (14; 114, 114', 114"; 214) ein Kantenfilter oder ein Bandpaßfilter ist.

6. Wellenlängenstabilisierte Laseranordnung nach einem der Ansprüche 2 bis 5, **dadurch gekennzeichnet, daß** ein weiteres Filter (17) zur Filterung des zum ersten Detektor (12; 112; 212) geführten ersten Teilstrahls (10; 110; 210) vorhanden ist.

7. Wellenlängenstabilisierte Laseranordnung nach Anspruch 6, **dadurch gekennzeichnet, daß** im Strahlengang des ersten Teilstrahls (10; 110; 210) zwischen dem ersten Polarisator (6; 106; 206) und dem weiteren Filter (17) ein λ/2-Plättchen angeordnet ist.

8. Wellenlängenstabilisierte Laseranordnung nach einem der Ansprüche 6 oder 7, **dadurch gekennzeichnet, daß** das weitere Filter (17) ein Kantenfilter oder ein Bandpaßfilter ist.

9. Wellenlängenstabilisierte Laseranordnung nach einem der vorhergehenden Ansprüche, **dadurch gekennzeichnet, daß** das Filter (14; 114, 114', 114"; 214) und, sofern vorhanden, das weitere Filter (17) ein Interferenzfilter oder ein Etalon sind.

10. Wellenlängenstabilisierte Laseranordnung nach einem der Ansprüche 6 bis 9, **dadurch gekennzeichnet, daß** das weitere Filter (17) eine gegenüber der Filterkurve des Filters (14; 114, 114', 114"; 214) verschobene und bezüglich der Sollwellenlänge $\lambda_0$ gegenläufige Filterkurve aufweist.

11. Wellenlängenstabilisierte Laseranordnung nach Anspruch 10, **dadurch gekennzeichnet, daß** die Filterkurve des Filters (14; 114, 114', 114"; 214) und die Filterkurve des weiteren Filters (17) bei der Sollwellenlänge $\lambda_0$ einen Schnittpunkt aufweisen.

12. Wellenlängenstabilisierte Laseranordnung nach einem der vorhergehenden Ansprüche, **dadurch gekennzeichnet, daß** das Filter (14; 114, 114"; 214) und/oder das weitere Filter (17) schwenkbar angeordnet sind.

13. Wellenlängenstabilisierte Laseranordnung nach einem der vorhergehenden Ansprüche, **dadurch gekennzeichnet, daß** der zweite Polarisator (108', 108") und/oder der erste Polarisator (6, 106, 206) schwenkbar angeordnet sind.

14. Wellenlängenstabilisierte Laseranordnung nach einem der Ansprüche 2 bis 13, **dadurch gekennzeichnet, daß** der zweite Polarisator (108") und das Filter (114") in zueinander lagefester Beziehung in einer gemeinsamen, schwenkbaren Einheit (115) angeordnet sind.

15. Wellenlängenstabilisierte Laseranordnung nach einem der vorhergehenden Ansprüche, **dadurch gekennzeichnet,**

- **daß** die Laseranordnung eine Ankoppeloptik mit einem eine Koppellinse tragenden Linsenträger zur Auskopplung eines von dem Halbleiterlaser emittierten Laserlichtbündels umfaßt, und
- **daß** der Linsenträger mittels Beaufschlagung durch einen Laserstrahl eines externen Justagelasers gezielt und dauerhaft verformbar ist.

16. Wellenlängenstabilisierte Laseranordnung nach einem der vorhergehenden Ansprüche, **dadurch gekennzeichnet, daß** die Einrichtung zum Drehen der Polarisationsebene ein Faradaydreher (7; 107; 207) ist.

17. Wellenlängenstabilisierte Laseranordnung nach Anspruch 16, **dadurch gekennzeichnet, daß** der Faradaydreher (7; 107; 207) selbst permanent magnetisiert ist.

18. Wellenlängenstabilisierte Laseranordnung nach einem der vorhergehenden Ansprüche, **dadurch gekennzeichnet, daß** der erste und/oder der zweite Detektor (12, 112, 212; 13, 113, 213) gegenüber dem ersten bzw. dem zweiten gefilterten Teilstrahl (10, 110, 210; 11', 111'; 211') verkippt angeordnet sind, derart, daß ein an dem Detektor auftretender Teilstrahlreflex aus dem entsprechenden Teilstrahlengang herausgespiegelt wird.

19. Wellenlängenstabilisierte Laseranordnung nach einem der vorhergehenden Ansprüche, **dadurch gekennzeichnet,**

- **daß** der Halbleiterlaser (1; 101) mit einer Kühleinrichtung (16; 116) in thermischen Kontakt steht, und
- **daß** mittels der Kühleinrichtung (16; 116) als wellenlängenselektiver Betriebsparameter die Temperatur des Halbleiterlasers (1; 101) eingestellt wird.

20. Wellenlängenstabilisierte Laseranordnung nach Anspruch 19, **dadurch gekennzeichnet, daß** der optische Isolator (5, 105, 215) und/oder das optische Filter (14; 114, 114', 114''; 214) ebenfalls mit der Kühleinrichtung (16, 116) in thermischen Kontakt steht.

21. Lasermodul, das

- eine wellenlängenstabilisierte Laseranordnung nach einem der vorhergehenden Ansprüche,
- ein hermetisch dichtes Modulgehäuse, das den Halbleiterlaser (1, 101), den optischen Isolator (5, 105, 205) und zumindest die optischen Detektoren (12, 112, 212; 13, 113, 213) und das optische Filter (14; 114, 114', 114''; 214) der Regeleinrichtung aufnimmt, und
- eine am oder außerhalb des Modulgehäuses vorgesehene Einrichtung zur Ankopplung einer optischen Faser (4)

umfaßt.

**Claims**

1. Wavelength-stabilized laser arrangement having

   - a semiconductor laser (1; 101) and
   - a regulating device comprising

     - - a first optical detector (12; 112; 212), to which is fed a first partial beam (10) coupled out by the semiconductor laser (1, 101),
     - - an optical filter (14; 114, 114', 114''; 214),
     - - a second optical detector (13; 113; 213), to which is fed a second partial beam (11'; 111'; 211') coupled out by the semiconductor laser (1, 101) and filtered by the optical filter (14; 114, 114', 114''; 214),
     - - a signal processing device (15a), to which an output signal ($I_1$) of the first optical detector (12, 112; 212) and an output signal ($I_2$) of the second optical detector (13; 113; 213) are fed and which determines from the two output signals ($I_1$, $I_2$) an actual value signal (ACTUAL($\lambda$)), which is representative of the instantaneous laser wavelength $\lambda$ and is independent of the laser power,
     - - a comparison device (15b), which compares the actual value signal (ACTUAL($\lambda$)) with a predetermined desired value signal (DESIRED), which specifies a desired wavelength $\lambda_0$, and

     - - a drive device (15c), which generates a control signal (C) that sets an operating parameter of the semiconductor laser, said parameter influencing the wavelength $\lambda$ to be stabilized, in such a way that the actual value signal (ACTUAL($\lambda$)) essentially corresponds to the desired value signal (DESIRED),

   - an optical isolator (5; 105; 205) arranged in the beam path (2, 102, 202) of the semiconductor laser and having

     - - a first polarizer (6; 106; 206),
     - - a device (7; 107; 207) for rotating the plane of polarization of the light, said device being connected downstream of the first polarizer (6; 106; 206), and
     - - a second polarizer (8; 108; 208), which is connected downstream of the device (7; 107; 207) for rotating the plane of polarization of the light,

   - at least one of the two polarizers (6; 106; 206; 8; 108; 208) being used as a beam splitter for coupling out the first or second partial beam (10; 110; 210; 11; 111; 211).

2. Wavelength-stabilized laser arrangement according to Claim 1, **characterized in that** the second polarizer (8; 108; 208) is used as a beam splitter for coupling out the second partial beam (11; 111; 211).

3. Wavelength-stabilized laser arrangement according to Claim 1 or 2, **characterized in that** the first polarizer (6; 106; 206) is used as a beam splitter for coupling out the first partial beam (10; 110; 210).

4. Wavelength-stabilized laser arrangement according to one of the preceding claims, **characterized in that** the polarizer or polarizers (6; 106; 206; 8; 108; 208) used as beam splitters are partly reflective polarization filters arranged at an inclination relative to an incident laser light pencil (2, 102, 202).

5. Wavelength-stabilized laser arrangement according to one of the preceding claims, **characterized in that** the optical filter (14; 114, 114', 114''; 214) is a cut-off filter or a bandpass filter.

6. Wavelength-stabilized laser arrangement according to one of Claims 2 to 5, **characterized in that** there is a further filter (17) present for filtering the first partial beam (10; 110; 210) guided to the first detector (12; 112; 212).

7. Wavelength-stabilized laser arrangement according to Claim 6, **characterized in that** a λ/2 plate is arranged in the beam path of the first partial beam (10; 110; 210) between the first polarizer (6; 106; 206) and the further filter (17).

8. Wavelength-stabilized laser arrangement according to either of Claims 6 and 7, **characterized in that** the further filter (17) is a cut-off filter or a bandpass filter.

9. Wavelength-stabilized laser arrangement according to one of the preceding claims, **characterized in that** the filter (14; 114; 114'; 114"; 214) and, if present, the further filter (17) are an interference filter or an etalon.

10. Wavelength-stabilized laser arrangement according to one of Claims 6 to 9, **characterized in that** the further filter (17) has a filter curve which is shifted relative to the filter curve of the filter (14; 114, 114', 114"; 214) and in the opposite direction with regard to the desired wavelength $\lambda_0$.

11. Wavelength-stabilized laser arrangement according to Claim 10, **characterized in that** the filter curve of the filter (14; 114, 114', 114"; 214) and the filter curve of the further filter (17) have a point of intersection at the desired wavelength $\lambda_0$.

12. Wavelength-stabilized laser arrangement according to one of the preceding claims, **characterized in that** the filter (14; 114, 114"; 214) and/or the further filter (17) are arranged in a manner that allows them or it to pivot.

13. Wavelength-stabilized laser arrangement according to one of the preceding claims, **characterized in that** the second polarizer (108', 108") and/or the first polarizer (6, 106, 206) are arranged in a manner that allows them or it to pivot.

14. Wavelength-stabilized laser arrangement according to one of Claims 2 to 13, **characterized in that** the second polarizer (108") and the filter (114") are arranged in a mutually positionally fixed relationship in a common, pivotable unit (115).

15. Wavelength-stabilized laser arrangement according to one of the preceding claims, **characterized**

   - **in that** the laser arrangement comprises an optical coupling unit with a lens carrier, carrying a coupling lens, for coupling out a laser light pencil emitted by the semiconductor laser, and
   - **in that** the lens carrier can be deformed in a targeted and permanent manner by being exposed to a laser beam from an external adjustment laser.

16. Wavelength-stabilized laser arrangement according to one of the preceding claims, **characterized in that** the device for rotating the plane of polarization is a Faraday rotator (7; 107; 207).

17. Wavelength-stabilized laser arrangement according to Claim 16, **characterized in that** the Faraday rotator (7; 107; 207) itself is permanently magnetized.

18. Wavelength-stabilized laser arrangement according to one of the preceding claims, **characterized in that** the first and/or the second detector (12, 112, 212; 13, 113, 213) are arranged in a tilted manner relative to the first and/or the second filtered partial beam (10, 110, 210; 11', 111; 211'), in such a way that a partial beam reflection occurring at the detector is reflected out of the corresponding partial beam path.

19. Wavelength-stabilized laser arrangement according to one of the preceding claims, **characterized**

   - **in that** the semiconductor laser (1; 101) is in thermal contact with a cooling device (16; 116), and
   - **in that** the temperature of the semiconductor laser (1; 101) is set as wavelength-selective operating parameter by means of the cooling device (16; 116).

20. Wavelength-stabilized laser arrangement according to Claim 19, **characterized in that** the optical isolator (5, 105, 215) and/or the optical filter (14; 114, 114', 114"; 214) are or is likewise in thermal contact with the cooling device (16, 116).

21. Laser module comprising

   - a wavelength-stabilized laser arrangement according to one of the preceding claims,
   - a hermetically sealed module housing which accommodates the semiconductor laser (1, 101), the optical isolator (5, 105, 205) and at least the optical detectors (12, 112, 212; 13, 113, 213) and the optical filter (14; 114, 114', 114"; 214) of the regulating device, and
   - a device for coupling an optical fiber (4), said device being provided on or outside the module housing.

**Revendications**

1. Dispositif laser à longueur d'onde stabilisée, comportant

- un laser à semi-conducteur (1 ; 101), et
- un dispositif de régulation qui comprend

  - - un premier détecteur optique (12 ; 112 ; 212) auquel est envoyé un premier faisceau partiel (10) sortant du laser à semi-conducteur (1, 101),
  - - un filtre optique (14 ; 114, 114', 114" ; 214),
  - - un deuxième détecteur optique (13 ; 113 ; 213) auquel est envoyé un deuxième faisceau partiel (11' ; 111' ; 211') sortant du laser à semi-conducteur (1, 101) et filtré par le filtre optique (14 ; 114, 114', 114" ; 214),
  - - un dispositif de traitement de signal (15a) auquel sont envoyés un signal de sortie ($I_1$) du premier détecteur optique (12 ; 112 ; 212) et un signal de sortie ($I_2$) du deuxième détecteur optique (13 ; 113 ; 213) et qui détermine à partir des deux signaux de sortie ($I_1$, $I_2$) un signal de valeur réelle (IST($\lambda$)) qui est représentatif de la longueur d'onde instantanée $\lambda$ et qui est indépendant de la puissance de laser,
  - - un dispositif de comparaison (15b) qui compare le signal de valeur réelle (IST ($\lambda$)) à un signal de valeur de consigne (SOLL) prédéterminé indiquant une longueur d'onde de consigne $\lambda_0$, et
  - - un dispositif de commande (15c) qui produit un signal de commande (C) qui règle un paramètre de fonctionnement, influençant la longueur d'onde à stabiliser $\lambda$, du laser à semi-conducteur de telle sorte que le signal de valeur réelle (IST ($\lambda$)) coïncide sensiblement avec le signal de valeur de consigne (SOLL),

- un isolant optique (5 ; 105 ; 205) placé dans le trajet des rayons (2, 102, 202) du laser à semi-conducteur et comprenant

  -- un premier polarisateur (6 ; 106 ; 206),
  -- un dispositif (7 ; 107 ; 207) placé du côté aval du premier polarisateur (6 ; 106 ; 206) et destiné à tourner le plan de polarisation de la lumière, et
  -- un deuxième polarisateur (8 ; 108 ; 208) placé du côté aval du dispositif (7 ; 107 ; 207) destiné à tourner le plan de polarisation de la lumière,

- au moins l'un des deux polarisateurs (6 ; 106 ; 206 ; 8 ; 108 ; 208) étant utilisé comme séparateur de faisceau pour la sortie du premier ou du deuxième faisceau partiel (10 ; 110 ; 210 ; 11 ; 111 ; 211 ).

2. Dispositif laser à longueur d'onde stabilisée selon la revendication 1, **caractérisé par le fait que** le deuxième polarisateur (8 ; 108 ; 208) est utilisé comme séparateur de faisceau pour la sortie du deuxième faisceau partiel (11 ; 111 ; 211 ).

3. Dispositif laser à longueur d'onde stabilisée selon la revendication 1 ou 2, **caractérisé par le fait que** le premier polarisateur (6 ; 106 ; 206) est utilisé comme séparateur de faisceau pour la sortie du premier faisceau partiel (10 ; 110 ; 210).

4. Dispositif laser à longueur d'onde stabilisée selon l'une des revendications précédentes, **caractérisé par le fait que** le ou les polarisateurs (6 ; 106 ; 206 ; 8 ; 108 ; 208) utilisés comme séparateurs de faisceau sont des filtres de polarisation semiréfléchissants, qui sont placés de façon inclinée par rapport à un faisceau de lumière laser incident (2, 102, 202).

5. Dispositif laser à longueur d'onde stabilisée selon l'une des revendications précédentes, **caractérisé par le fait que** le filtre optique (14 ; 114, 114', 114" ; 214) est un filtre interférentiel à limite de transmission ou un filtre passe-bande.

6. Dispositif laser à longueur d'onde stabilisée selon l'une des revendications 2 à 5, **caractérisé par le fait qu'**un filtre supplémentaire (17) est prévu pour le filtrage du premier faisceau partiel (10 ; 110 ; 210) envoyé au premier détecteur (12 ; 112 ; 212).

7. Dispositif laser à longueur d'onde stabilisée selon la revendication 6, **caractérisé par le fait qu'**une lame $\lambda/2$ est placée dans le trajet des rayons du premier faisceau partiel (10 ; 110 ; 210) entre le premier polarisateur (6 ; 106 ; 206) et le filtre supplémentaire (17).

8. Dispositif laser à longueur d'onde stabilisée selon l'une des revendications 6 ou 7, **caractérisé par le fait que** le filtre supplémentaire (17) est un filtre interférentiel à limite de transmission ou un filtre passe-bande.

9. Dispositif laser à longueur d'onde stabilisée selon l'une des revendications précédentes, **caractérisé par le fait que** le filtre (14 ; 114, 114', 114" ; 214) et, dans la mesure où il est prévu, le filtre supplémentaire (17) est un filtre interférentiel ou un étalon.

10. Dispositif laser à longueur d'onde stabilisée selon l'une des revendications 6 à 9, **caractérisé par le fait que** le filtre supplémentaire (17) a une courbe de filtrage décalée par rapport à la courbe de filtrage du filtre (14 ; 114, 114', 114" ; 214) et en sens contraire par rapport à la longueur d'onde de consigne $\lambda_0$.

**11.** Dispositif laser à longueur d'onde stabilisée selon la revendication 10, **caractérisé par le fait que** la courbe de filtrage du filtre (14 ; 114, 114', 114" ; 214) et la courbe de filtrage du filtre supplémentaire (17) ont un point d'intersection à la longueur d'onde de consigne $\lambda_0$.

**12.** Dispositif laser à longueur d'onde stabilisée selon l'une des revendications précédentes, **caractérisé par le fait que** le filtre (14 ; 114, 114" ; 214) et/ou le filtre supplémentaire (17) sont agencés de manière à pouvoir pivoter.

**13.** Dispositif laser à longueur d'onde stabilisée selon l'une des revendications précédentes, **caractérisé par le fait que** le deuxième polarisateur (108', 108") et/ou le premier polarisateur (6, 106, 206) sont agencés de manière à pouvoir pivoter.

**14.** Dispositif laser à longueur d'onde stabilisée selon l'une des revendications 2 à 13, **caractérisé par le fait que** le deuxième polarisateur (108") et le filtre (114") sont agencés, dans une position fixe l'un par rapport à l'autre, dans une unité commune pivotante (115).

**15.** Dispositif laser à longueur d'onde stabilisée selon l'une des revendications précédentes, **caractérisé par le fait que**

- le dispositif laser comprend une optique de couplage ayant un support de lentille portant une lentille de couplage pour la sortie d'un faisceau de lumière laser émis par le laser à semi-conducteur, et
- le support de lentille est déformable de manière ciblée et durable par l'application d'un faisceau laser d'un laser d'ajustage externe.

**16.** Dispositif laser à longueur d'onde stabilisée selon l'une des revendications précédentes, **caractérisé par le fait que** le dispositif pour la rotation du plan de polarisation est un dispositif de rotation Faraday (7 ; 107 ; 207).

**17.** Dispositif laser à longueur d'onde stabilisée selon la revendication 16, **caractérisé par le fait que** le dispositif de rotation Faraday (7 ; 107 ; 207) est auto-magnétisé en permanence.

**18.** Dispositif laser à longueur d'onde stabilisée selon l'une des revendications précédentes, **caractérisé par le fait que** le premier et/ou le deuxième détecteur (12, 112, 212 ; 13, 113, 213) sont basculés par rapport au premier ou au deuxième faisceau partiel filtré (10, 110, 210 ; 11', 111 ; 211') de telle sorte qu'un reflet de faisceau partiel arrivant sur le détecteur est réfléchi hors du trajet des rayons du faisceau partiel considéré.

**19.** Dispositif laser à longueur d'onde stabilisée selon l'une des revendications précédentes, **caractérisé par le fait que**

- le laser à semi-conducteur (1 ; 101) est en contact thermique avec un dispositif de refroidissement (16 ; 116), et
- au moyen du dispositif de refroidissement (16 ; 116), on règle comme paramètre de fonctionnement sélectif en longueur d'onde la température du laser à semi-conducteur (1 ; 101).

**20.** Dispositif laser à longueur d'onde stabilisée selon la revendication 19, **caractérisé par le fait que** l'isolant optique (5, 105, 215) et/ou le filtre optique (14 ; 114, 114', 114" ; 214) sont également en contact thermique avec le dispositif de refroidissement (16, 116).

**21.** Module laser qui comprend

- un dispositif laser à longueur d'onde stabilisée selon l'une des revendications précédentes,
- un boîtier de module hermétiquement étanche, qui contient le laser à semi-conducteur (1, 101), l'isolant optique (5, 105, 205) et au moins les détecteurs optiques (12, 112, 212 ; 13, 113, 213) et le filtre optique (14 ; 114, 114', 114" ; 214) du dispositif de régulation, et
- un dispositif, prévu sur ou à l'extérieur du boîtier de module, pour le couplage d'une fibre optique (4).

FIG 1

EP 0 967 698 B1

FIG 2

FIG 3 A

FIG 3 B

FIG 3 C

FIG 4

FIG 5

FIG 6

132

103

102

105

106    107    108"    115

110

111

114"

111'

112    113

134

EP 0 967 698 B1

17

# FIG 7A

# FIG 7B